# EUROPÄISCHE PATENTSCHRIFT

(11) **EP 2 726 784 B1**
(45) Veröffentlichungstag und Bekanntmachung des Hinweises auf die Patenterteilung: **20.07.2016**
(21) Anmeldenummer: 12729992.3
(22) Anmeldetag: 29.06.2012
(51) Int. Cl.: F21V 25/12, F21V 31/04, F21V 19/00, F21Y 115/00, F21S 4/00, H01L 33/58

(54) **LEUCHTE MIT VERGUSSMASSE**
LUMINAIRE WITH A POTTING COMPOUND
SYSTÈME D'ÉCLAIRAGE MUNI D'UNE MATIÈRE D'ÉTANCHÉITÉ ET DE SCELLEMENT

(30) Priorität: 01.07.2011 DE 102011106252
(43) Veröffentlichungstag der Anmeldung: 07.05.2014
(73) Patentinhaber: Siteco Beleuchtungstechnik GmbH, 83301 Traunreut (DE)
(72) Erfinder: ZWEILING, Benjamin, 98693 Ilmenau (DE); WEBER, Rainer, 83313 Siegsdorf (DE)
(74) Vertreter: Schmidt, Steffen
(86) Internationale Anmeldenummer: PCT/EP2012/062668
(87) Internationale Veröffentlichungsnummer: WO 2013/004608

(56) Entgegenhaltungen:
- EP-A2- 1 681 202
- DE-A1- 19 904 915
- DE-A1-102004 004 432
- DE-A1-102005 025 214
- DE-A1-102009 008 845
- DE-A1-102009 014 514
- DE-A1-102009 024 828
- DE-U1-202011 003 828
- US-A1- 2004 246 741
- US-A1- 2007 258 244

## Beschreibung

Die vorliegende Erfindung betrifft Leuchten, insbesondere auf LED-Technik beruhend, welche einen robusten widerstandsfähigen Aufbau aufweisen, sowie ein Herstellungsverfahren der Leuchten.

Leuchten, die widerstandsfähig und belastbar sind, sowie für den Einsatz in Feuchträumen, in Kühlräumen oder explosionsgefährdeten Räumen, erfordern in der Regel eine vollständige Kapselung des Leuchtmittels. Bei der Verwendung von langlebigen Leuchtmitteln, wie z. B. LEDs (lichtemittierende Dioden, worunter auch organische lichtemittierende Dioden zu verstehen sind), welche über die Lebensdauer der Leuchte nicht ausgetauscht werden müssen, können die Leuchtmittel vollständig und dauerhaft versiegelt werden.

Ein Beispiel einer besonders robusten Leuchte ist in DE 20 2008 012 002 U1 beschrieben. Für den Einsatz im Off-Shore-Bereich wird eine Leuchte aus einer Reihe von LEDs gebildet, die in einem U-förmigen Kanal angeordnet sind und von der Lichtaustrittsseite vollständig durch eine transparente Vergussmasse eingegossen werden. Die Oberfläche der Vergussmasse bildet die Lichtaustrittsseite der Leuchte.

Aus der DE 20 2009 002 127 U1 ist eine LED-Leuchte bekannt, in welcher LEDs vollständig hermetisch gegen Feuchtigkeitseinfluss abgeschlossen sind. Auch bei dieser Leuchte werden LEDs in ein vorgefertigtes Gehäuse eingebracht, welches anschließend mit einer transparenten Vergussmasse ausgefüllt wird, wobei die Vergussmasse den Gehäusedeckel, welcher als Lichtaustrittsfläche dient, bildet.

Lichttechnisch bieten die vorhergehend genannten Leuchten den Nachteil, dass sie oftmals nur eine mindere optische Qualität aufweist, weil die Lichtaustrittsfläche durch eine nachträglich aufgebrachte Vergussmasse gebildet wird.

US 2004/0246741 A1, DE 199 04 915 A1, EP 1 681 202 A2, DE 10 2005 025 214 A1 und DE 10 2004 004 432 A1 offenbaren verschiedene Formen von Leuchten mit LEDs als Leuchtmitteln. Die LEDs sind gegenüberliegend einer Lichtaustrittsfläche in einem Leuchtenkörper auf einer Platine angeordnet, wobei die Platine mit Vergussmasse am Leuchtenkörper fixiert wird.

Aus der US 2007/0258244 A1 ist eine LED-Lichtquelle bekannt, bei welcher Reflektorelemente oder Linsenelement an den LEDs vorgesehen sind, um das Licht der LEDs in Richtung zu einer den LEDs gegenüberliegenden Lichtaustrittsfläche zu lenken.

Aus der DE 10 2009 008 845 A1 ist ein Leuchtenmodul bekannt, welches u.a. seitlich emittierende LEDs aufweist, die seitlich der Lichtaustrittsfläche des Leuchtenmoduls an einer Innenwand eines Profils befestigt werden. Der Innenraum des Profils sowie der Bereich der Lichtaustrittsfläche werden mit Vergussmaterial, und insbesondere mit transparentem Vergussmaterial zur Bildung der Lichtaustrittsfläche aufgefüllt.

Aufgabe der vorliegenden Erfindung ist es, eine einfach herzustellende Leuchte bereitzustellen, welche äußerst widerstandsfähig gegen äußere Einflüsse ist, eine hohe optische Qualität aufweist und dennoch einfach herzustellen ist.

Die Erfindung wird gelöst durch eine Leuchte nach Anspruch 1.

Durch die Verwendung des vorgeformten Leuchtenkörpers, welcher mit dem transparenten Abschnitt die Lichtaustrittsfläche der Leuchte definiert, kann eine hohe optische Qualität erzielt werden. Das Eingießen des Leuchtmittelträgers wirkt sich nicht oder nur geringfügig auf die erzeugte Lichtverteilung aus, weil die Oberfläche, über die das Licht die Leuchte verlässt, durch den vorgefertigten Leuchtenkörper, welcher mit entsprechend hoher optischer Qualität hergestellt werden kann, gebildet wird. Ferner bietet die Verwendung der Vergussmasse eine besonders einfache Möglichkeit, die Leuchte herzustellen, weil nach dem Verguss die Oberfläche der Vergussmasse nicht nachbearbeitet werden muss, um eine hohe optische Qualität zu erzeugen. Ferner bietet der vorgefertigte Leuchtenkörper den Vorteil, dass lichtbrechende oder lichtreflektierende (Totalreflexion) Elemente bei der Vorfertigung bereits integriert werden können. Ferner kann durch das Vergießen eine hohe Dichtigkeit der Leuchte, z.B. für den Einsatz in Feuchträumen, in Kühlräumen oder sogar in explosionsgefährdeten Räumen, erzielt werden.

Gemäß einer bevorzugten Ausführungsform ist der Ausschnitt für das Einsetzen des Leuchtmittelträgers durch gegenüberliegende Elemente gebildet, die formschlüssig an dem Leuchtmittelträger angreifen. Insbesondere ist eine Rastverbindung zwischen den gegenüberliegenden Elementen und dem Leuchtmittelträger bevorzugt. Alternativ können die gegenüberliegenden Elemente auch eine Form aufweisen, die das seitliche Einschieben des Leuchtmittelträgers in den Leuchtenkörper ermöglichen. Diese Ausführungsformen haben den Vorteil, dass der Leuchtmittelträger in einer durch den Formschluss vorgegebenen Position an dem Leuchtenträger vormontiert werden kann, bevor der Leuchtenkörper mit der Vergussmasse endgültig fixiert ist. Gemäß einer bevorzugten Ausführungsform ist die Position des Leuchtmittelträgers gegenüber dem Leuchtenkörper durch die gegenüberliegenden Elemente des Ausschnitts vollständig in alle Richtungen festgelegt.

Erfindungsgemäß ist der Leuchtmittelträger seitlich des transparenten Abschnitts in dem Ausschnitt angeordnet sein. Ferner ist im Inneren des Leuchtenkörpers ein lichtlenkendes Element, z.B. ein Reflektor oder ein lichtbrechendes Element, wie ein Prisma, vorgesehen, um das Licht der Leuchtmittel zum transparenten Abschnitt des Leuchtenkörpers umzulenken.

Gemäß einer Ausführungsform kann der Ausschnitt auch als eine seitlich des transparenten Abschnitts geöffnete Tasche gebildet sein. Bei dieser Ausführungsform wird der Leuchtmittelträger seitliche in den Leuchtenkörper eingeschoben. Bei dieser Ausführungsform wird vorzugsweise die Tasche vollständig mit einer transparenten Vergussmasse aufgefüllt. Da die Oberfläche der Vergussmasse jedoch nicht die Lichtaustrittsseite der Leuchte bildet, sondern der transparente Abschnitt des vorgefertigten Leuchtenkörpers, wird die optische Qualität der Leuchte durch Unebenheiten in der Oberfläche der Vergussmasse nicht beeinträchtigt.

Gemäß einer bevorzugten Ausführungsform ist das Leuchtmittel, insbesondere die vollständige Seite des Leuchtmittelträgers, auf welcher das Leuchtmittel angeordnet ist, frei von Vergussmasse. Beispielsweise wird zwischen dem Leuchtmittel und dem transparenten Abschnitt ein Hohlraum gebildet. Bei dieser Ausführungsform wird kein Licht durch die Vergussmasse absorbiert, weil die Vergussmasse sich nicht in den lichtführenden Teilen des Leuchtenkörpers befindet. Selbst bei Vergussmassen mit hoher Lichtdurchlässigkeit kann durch Einschlüsse, wie z.B. Luftblasen, eine Lichtstreuung oder -absorption kaum verhindert werden.

Gemäß einer alternativen Ausführungsform ist die Vergussmasse transparent ausgebildet und füllt einen Bereich zwischen dem Leuchtmittel und dem transparenten Abschnitt vorzugsweise vollständig aus. Bei dieser Ausführungsform kann insbesondere der Brechungsindex der Vergussmasse entsprechend dem Brechungsindex des transparenten Abschnitts oder genauer gesagt der dem Leuchtmittel zugewandten Seite des transparenten Abschnitts gewählt werden, so dass eine Lichtreflexion beim Übertritt des Lichts von der Vergussmasse in den transparenten Abschnitt verhindert werden kann. Auch bei dieser Ausführungsform wird jedoch die Oberfläche der Lichtaustrittsfläche durch den vorgefertigten Leuchtenkörper gebildet, so dass eine Unregelmäßigkeit der Oberfläche der Vergussmasse sich nicht negativ auf die optischen Eigenschaften der Leuchte auswirkt.

Beim vollständigen Vergießen des Bereichs zwischen dem Leuchtmittel und dem transparenten Abschnitt ist der Brechungsindex der Vergussmasse vorzugsweise so gewählt, dass er sich nicht mehr als 15 %, vorzugsweise nicht mehr als 5 % von dem Brechungsindex des transparenten Abschnitts auf der zum Leuchtmittel gewandten Seite unterscheidet, um die Lichtreflexion an der Grenzfläche zwischen der Vergussmasse und dem transparenten Abschnitt gering zu halten.

Gemäß einer bevorzugten Ausführungsform weist der transparente Abschnitt eine nicht-ebene Oberflächengeometrie auf, welche durch Lichtbrechung eine Änderung der Lichtverteilung des von dem Leuchtmittel abgegebenen Lichts hervorruft. Die Oberflächengeometrie des transparenten Abschnitts kann entsprechend einer gewünschten Lichtverteilungskurve gewählt werden. Der transparente Abschnitt kann beispielsweise in der Art einer Linse wirken. Gemäß weiteren Ausführungsformen kann der transparente Abschnitt sogar Prismenflächen aufweisen, die eine Totalreflexion bewirken, so dass das Licht auch durch Reflektion im transparenten Abschnitt in die gewünschte Richtung gelenkt wird.

Gemäß einer bevorzugten Ausführungsform ist der Leuchtenkörper als ein sich längs erstreckendes Profil ausgebildet und der Leuchtmittelträger weist mehrere Leuchtmittel, insbesondere eine Reihe oder mehrere z.B. parallele Reihen von LEDs, entlang des Profils auf. Die Leuchte lässt sich z.B. entlang eines Randes oder in einem Handlauf eines Kühlgerätes zur gleichmäßigen Beleuchtung eines Innenraums einfügen. Die Abdichtung einer sehr schmalen und langen Leuchte ist mit herkömmlichen Mittel verhältnismäßig aufwändig, weil sich das Gehäuse über die Länge leicht verziehen kann. Durch das Eingießen des Leuchtmittelträgers ist die Abdichtung jedoch einfach herzustellen. Ferner verleiht die ausgehärtete Gussmasse der Leuchte eine zusätzliche mechanische Stabilität.

Gemäß einer bevorzugten Ausführungsform ist in einem Bereich, vorzugsweise in einem Hohlraum, zwischen dem Leuchtmittelträger und dem transparenten Abschnitt ein lichtlenkendes Element, insbesondere ein Reflektor, angeordnet. Der Reflektor kann dazu dienen, eine gewünschte Lichtverteilung zu erzeugen. Da der Reflektor oder ein anderes lichtlenkendes Element vollständig in dem Leuchtenkörper gekapselt angeordnet ist, kann auch durch Fremdkörper oder Feuchtigkeit die optische Qualität der Reflektionsfläche nicht beeinträchtigt werden.

Gemäß einer bevorzugten Ausführungsform ist an dem Leuchtmittelträger und/oder an dem Leuchtenkörper ein Federelement durch die Vergussmasse fixiert. Das Federelement kann dazu dienen, die Leuchte an einem gewünschten Einbauort, z.B. in einem Rahmen oder einem Handlauf einer Kühltruhe, zu befestigen.

Gemäß einer bevorzugten Ausführungsform bedeckt die Vergussmasse die gesamte Oberfläche des Leuchtmittelträgers, welche nicht von dem Leuchtenkörper oder einem Hohlraum in diesem abgedeckt ist. Dadurch ist der Leuchtmittelträger von allen Seiten abgeschlossen. Durch die Vergussmasse lässt sich ein Berührschutz gegenüber den elektrisch leitenden Teilen herstellen und eine feuchtigkeitsdichte Versieglung des Leuchtmittelträgers bilden. Dadurch sind alle elektronischen Bauelemente oder Lötstellen, die an der Leuchte vorgesehen sind, korrosionsgeschützt und alle stromführenden Leitungen werden in einem einzigen Arbeitsschritt durch die Vergussmasse nach außen unzugänglich, um z.B. einem elektrischen Überschlag vorzubeugen.

Der flächige Leuchtmittelträger kann gemäß verschiedener Ausführungsformen einteilig oder aus mehreren Teilen, z.B. Platinenabschnitten, gebildet sein.

Gemäß einer bevorzugen Ausführungsform ist ein Endabschnitt einer elektrischen Anschlussleitung des Leuchtmittelträgers ebenfalls in die Vergussmasse eingegossen. Die Vergussmasse dient in diesem Fall auch als Zugentlastung der elektrischen Anschlussleitung.

Ein weiterer Aspekt der Erfindung betrifft ferner ein Verfahren zur Herstellung der vorhergehend beschriebenen Ausführungsformen der Leuchte, wobei das Verfahren in zwei zeitlich aufeinanderfolgenden Verfahrensschritten zuerst ein Vormontieren des Leuchtmittelträgers an dem Leuchtenkörper und in einem nachfolgenden Verfahrensschritt das Vergießen mit der Vergussmasse umfasst. Im Vergleich zu einem Verfahren, bei welchem Leuchtmittel in einem einzigen Arbeitsschritt vergossen werden, ist das Herstellungsverfahren einfacher durchzuführen, weil die Oberflächen der Vergussmasse zur Erzielung einer hohen optischen Qualität nicht nachgearbeitet werden muss. Ferner bietet das Vormontieren den Vorteil, dass die Position der Leuchtmittelträger und damit die Position der Leuchtmittel bereits festgelegt ist, bevor die Vergussmasse ggf. in einer separaten Maschine aufgebracht wird.

Weitere Merkmale und Vorteile der vorliegenden Erfindung werden anhand der nachfolgend beschriebenen bevorzugten Ausführungsformen in Verbindung mit den beigefügten Figuren dargestellt.
- Figur 1: zeigt einen Querschnitt durch eine Leuchte;
- Figur 2: zeigt einen Querschnitt durch eine erfindungsgemäße Ausführungsform einer Leuchte, welche in einen Handlauf eines Kühlgerätes montiert ist;
- Figur 3: zeigt in einem Querschnitt den Leuchtenkörper der Ausführungsform nach Figur 2;
- Figur 4: zeigt einen Querschnitt durch eine Leuchte mit einem Lichtstrahlenbündel;
- Figur 5: zeigt einen Querschnitt durch eine weitere Leuchte; und
- Figur 6: zeigt einen Querschnitt durch eine weitere Leuchte.

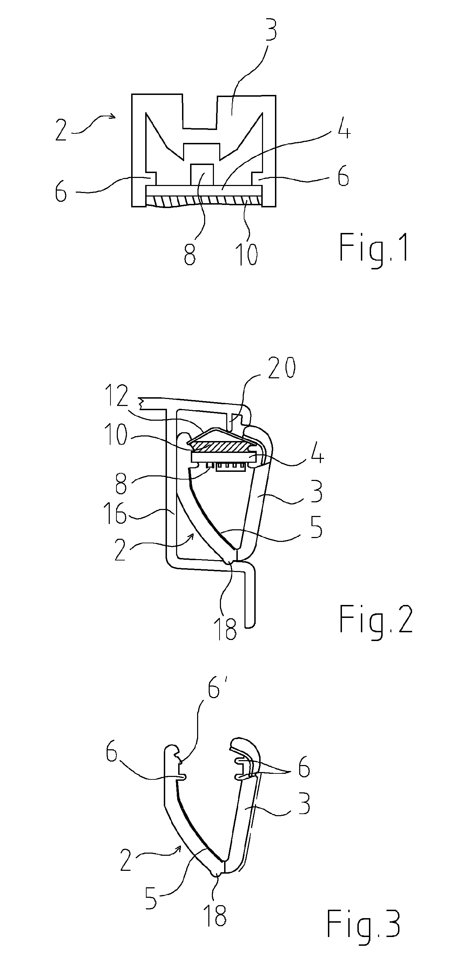

Bezug nehmend auf Figur 1 wird eine erste Leuchte beschrieben. Die Leuchte weist einen im Querschnitt in etwa U-förmigen Körper 2 auf, welcher in der dargestellten Ausführungsform vollständig aus einem transparenten Material hergestellt ist. Von der Unterseite des Leuchtenkörpers 2 ist ein Leuchtmittelträger 4 in Form einer ebenen Platine eingesteckt. Der Leuchtmittelträger ist in einem Ausschnitt des Leuchtenkörpers 2 gehalten, der auf zwei gegenüberliegenden Seiten Vorsprünge 6 aufweist, welche an den Rändern des Leuchtmittelträgers 4 formschlüssig anliegen. Auf der zum Leuchtenkörper 2 gewandten Seite des Leuchtmittelträgers 4 sind in einer Reihe mehrere LEDs 8 angeordnet, wobei in der Schnittzeichnung nach Figur 1 nur der Schnitt durch eine LED zu sehen ist.

Auf der den LEDs 8 entgegengesetzten Seite des Leuchtmittelträgers 4 ist die Oberfläche des Leuchtmittelträgers 4 vollständig mit einer Vergussmasse 10 abgedeckt. Zur Herstellung der Leuchte wird zunächst der Leuchtmittelträger 4 in den offenen rückseitigen Ausschnitt des Leuchtenkörpers 2 eingesteckt, bis der Leuchtmittelträger 4 formschlüssig an den Vorsprüngen 6 anliegt. Erst anschließend wird die Vergussmasse 10 aufgebracht.

Die Vergussmasse 10 ist vorzugsweise durch ein Kunststoffmaterial, insbesondere durch einen Thermoplasten oder einen Doroplasten gebildet. Bevorzugt sind Epoxydharze, Polyurethan oder auf Silikon basierende Vergussmassen.

Die LEDs 8 sind elektrisch mit dem Leuchtmittelträger 4 verbunden, auf dem aufgedruckte Leiterbahnen und Kontaktstellen für die LEDs vorgesehen sind. Durch das Aufbringen der Vergussmasse 10 auf die Rückseite des Leuchtmittelträgers 4 sind alle Leiterbahnen auf der Außenseite vollständig abgedeckt, so dass ein Feuchtigkeitsschutz und ein Berührschutz gegeben ist. Ferner wird durch die Vergussmasse 10 der Leuchtmittelträger 4 mechanisch in dem Leuchtenkörper 2 fixiert.

Im Bereich zwischen der mit den LEDs 8 bestückten Oberfläche des Leuchtmittelträgers 4 und dem Leuchtenkörper 2 wird ein Hohlraum gebildet, welcher bei dieser Ausführungsform nicht ausgefüllt ist.

Das Licht der LEDs 8 wird über die Oberflächen des Leuchtenkörpers 2, der vollständig als transparenter Körper 3 ausgebildet ist, abgegeben. Die Form des Leuchtenkörpers 2 ist so gestaltet, dass der Lichtkegel der LED 8 durch Lichtbrechung zur Erzielung einer gewünschten Lichtverteilung umgelenkt wird.

Bezugnehmend auf die Figuren 2 und 3 sind Ausführungsformen der vorliegenden Erfindung beschreiben, wobei gleiche Bezugszeichen für die der vorhergehend beschriebenen Ausführungsform entsprechenden Elemente verwendet sind.

Ein Leuchtenkörper 2 ist im Querschnitt etwa V-förmig ausgebildet, wobei ein Abschnitt 3 eines Schenkels aus einem transparenten Material gebildet ist. Dieser Abschnitt dient als Lichtaustrittsfläche für die Leuchte. Die übrigen Bereiche des Leuchtenkörpers 2 sind aus Kunststoff oder aus Metall ausgebildet. Die dem transparenten Abschnitt 3 gegenüberliegende Innenseite des Leuchtenkörpers 2 ist mit einer reflektierenden Beschichtung 5 überzogen oder mit einem eingeformten Metallreflektor versehen.

Der Leuchtenkörper 2 bildet zwischen den gegenüberliegenden Schenkeln einen Ausschnitt, welcher gegenüberliegende, nach innen weisende Vorsprünge 6 aufweist. Die Vorsprünge können in Längsrichtung der Leuchte (senkrecht zur Bildebene der Figuren 2 und 3) sich durchgängig erstrecken. Einer der Vorsprünge ist als Rastnase 6' mit einer abgeschrägten Anlauffläche ausgebildet. Zur Montage der Leuchte wird der Leuchtmittelträger 4 in den Leuchtenkörper 2 eingesteckt, bis die Rückseite des Leuchtmittelträgers 4 hinter der Rastnase 6' einrastet. In dieser Position ist der Leuchtmittelträger bereits festgelegt. Anschließend werden in vorgegebenen Abständen Blattfedern 12 an dem Leuchtenkörper 2 angeklipst. Durch Aufbringen einer Vergussmasse 10 auf die Rückseite des Leuchtmittelträgers 4 wird sowohl der Leuchtmittelträger 4 als auch die Federn 12 an dem Leuchtenkörper 2 fixiert. Auch bei dieser Ausführungsform deckt die Vergussmasse 10 die Rückseite des Leuchtmittelträgers 4 vollständig ab, so dass alle elektrischen Kontakte vor Berührung und vor Feuchtigkeit geschützt sind. Auf der zum Reflektor 5 weisenden Seite des Leuchtmittelträgers 4 ist eine Reihe von LEDs angebracht, deren Licht teilweise über den Reflektor 5 und teilweise direkt durch den transparenten Abschnitt 3 von dem Leuchtenkörper 2 abgegeben wird. Bei dieser Ausführungsform ist der Reflektor 5 konkav gekrümmt, um eine gewünschte Lichtbündelung zu erzielen.

In dem Leuchtenkörper 2 ist im Bereich oberhalb des transparenten Abschnitts 3 hinter den Vorsprüngen 6 auf einer Seite eine Aluminiumblechschiene 14 zur Versteifung und als ein Gegenzug zu thermischen Spannungen in dem Leuchtenkörper angebracht. Alternativ kann auch ein Glasgeflecht oder eine andere Faserstruktur zur Verstärkung vorgesehen sein. Der Leuchtenkörper 2 ist bei dieser Ausführungsform aus einem co-extrudierten Kunststoff hergestellt, wobei der Abschnitt 3 aus einem transparenten Kunststoff hergestellt ist, welcher in dieser Ausführungsform lichtstreuend ausgebildet ist, während die übrigen Abschnitte des Leuchtenkörpers aus einem lichtdichten Kunststoff bzw. aus Metall gebildet sind.

Die Leuchte der Ausführungsform nach Figuren 2 und 3 ist zum Einbau in einem vorhandenen Einbaurahmen 16 vorgesehen, welcher durch den Handlauf einer Kühltruhe bei dieser Ausführungsform gebildet wird. Zur Befestigung der Leuchte in dem Einbaurahmen 16 befindet sich auf der der Feder 12 gegenüberliegenden Seite des Leuchtenkörpers ein Vorsprung 18, der in eine entsprechende Vertiefung des Einbaurahmens 16 eingesetzt wird. An der gegenüberliegenden Seite des Leuchtenkörpers wird die Leuchte mit der Feder 12 elastisch gegen einen Steg 20 des Einbaurahmens eingerückt.

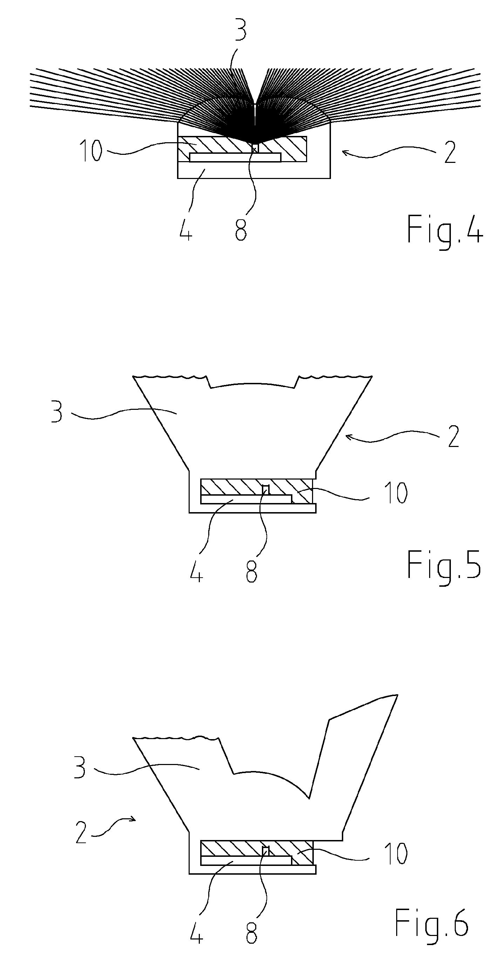

Bezugnehmend auf die Figuren 4-6 werden drei weitere Leuchten beschrieben, wobei für die den vorhergehend beschriebenen Ausführungsformen entsprechenden Teile die gleichen Bezugszeichen verwendet werden.

Bei diesen Leuchten ist in dem Leuchtengehäuse 2, welches aus einem co-extrudierten Kunststoff hergestellt ist, eine seitliche Tasche gebildet. Der Bereich 3 oberhalb der Tasche nimmt in den drei Ausführungsformen verschiedene Geometrien an, um eine gewünschte Berechnung und/oder Lichtreflexion zu erzeugen.

In die Tasche ist ein Leuchtmittelträger 4 eingesteckt. Die Tasche ist mit einem lichttransparenten Vergussmaterial 10 vollständig ausgefüllt. Das Vergussmaterial 10 ist so ausgewählt, dass der Berechnungsindex im ausgehärteten Zustand annähernd gleich zu dem Brechungsindex des transparenten Abschnitts 3 des Leuchtenkörpers 2 ist. Dadurch kann Lichtreflexion beim Übertritt des Lichts aus der Vergussmasse 3 in den transparenten Abschnitt 3 des Leuchtenkörpers weitgehend verhindert werden.

Der transparente Abschnitt 3 des Lichtkörpers 2 besitzt verschiedene Oberflächengestaltungen zur Lichtbrechung und/oder zur Lichtreflexion, um eine gewünschte Lichtverteilung zu erzeugen. Gemäß der Ausführungsform nach Figur 4 sind zwei konkave Abschnitte gebildet, die sich durchgängig senkrecht zur Bildebene in der Figur erstrecken und als lineare Umlenklinsen wirken, die das Lichtbündel z.B. aufweiten. Die zwei konkaven Abschnitte sorgen für eine Aufspaltung des Lichtbündels in zwei Teillichtbündel, die zu beiden Seiten der vertikalen Mittelebene des Leuchtenkörpers 2 abgelenkt werden.

Gemäß der Ausführungsform nach Figur 5 besitzt der transparente Abschnitt mittig oberhalb der LEDs 8 einen konkaven Abschnitt, der in der Art einer Sammellinse wirkt. Ferner sind zwei symmetrische Schenkelabschnitte seitlich des konkaven Abschnitts vorgesehen. Die äußeren Seitenflächen der Schenkelabschnitte weisen einen Winkel gegenüber der Hauptstrahlrichtung der LEDs 8 auf, so dass an den Außenflächen wenigstens teilweise Totalreflexion stattfindet. Das Licht wird dadurch in Richtung zur Hauptabstrahlrichtung der LED fokussiert.

Gemäß der Figur 6 sind im Vergleich zu der Figur 5 zwei asymmetrische Schenkelabschnitte vorgesehen, die durch einen asymmetrischen konkaven Abschnitt verbunden sind. Diese Ausführungsform erzeugt eine in Bezug auf vertikale Mittelebenen der Leuchte asymmetrische Lichtverteilung.

### Bezugszeichenliste

- 2: Leuchtenkörper
- 3: transparenter Abschnitt
- 4: Leuchtmittelträger
- 6: Vorsprung
- 6': Rastnase
- 8: LED
- 10: Vergussmasse
- 12: Feder
- 14: Versteifung
- 16: Einbaurahmen
- 18: Vorsprung
- 20: Steg

## Patentansprüche

1. Leuchte umfassend einen vorgeformten Leuchtenkörper (2) mit einem transparenten Abschnitt, der eine Lichtaustrittsfläche der Leuchte bildet, und einen flächigen Leuchtmittelträger (4), welcher wenigstens ein Leuchtmittel (8), insbesondere eine oder mehrere LEDs, sowie elektrische Kontaktierungsmittel für das Leuchtmittel (8) aufweist, wobei der Leuchtmittelträger (4) in einem Ausschnitt des Leuchtenkörpers (2) eingesetzt ist und anschließend durch eine Vergussmasse (10), welche von dem transparenten Abschnitt (3) des Leuchtenkörpers (2) verschieden ist, nach dem Aushärten, an dem Leuchtenkörper (2) fixiert ist, **dadurch gekennzeichnet, dass** der Leuchtmittelträger (4) seitlich des transparenten Abschnitts (3) in einem Ausschnitt angeordnet ist und ein lichtlenkendes Element (5) vorgesehen ist, um das Licht der Leuchtmittel zum transparenten Abschnitt (3) des Leuchtenkörpers (2) umzulenken.

2. Leuchte nach Anspruch 1, wobei der Ausschnitt durch gegenüberliegende Elemente (6, 6') gebildet ist, die formschlüssig an dem Leuchtmittelträger (4) angreifen, insbesondere eine Rastverbindung mit dem Leuchtmittelträger eingehen oder zum Einschieben des Leuchtmittelträgers in den Leuchtenkörper eingerichtet sind.

3. Leuchte nach Anspruch 2, wobei die gegenüberliegenden Elemente (6, 6') des Ausschnitts eingerichtet sind, um den Leuchtmittelträger (4) bereits vor dem Fixieren durch die Verguss an dem Leuchtenkörper (2) in Position zu halten.

4. Leuchte nach einem der vorhergehenden Ansprüche, wobei der Leuchtmittelträger (4) mit einer das Leuchtmittel (8) aufweisenden Seite seitlich des transparenten Abschnitts (3) in dem Ausschnitt angeordnet ist.

5. Leuchte nach einem der Ansprüche 1 bis 4, wobei der Ausschnitt durch eine zu dem transparenten Abschnitt (3) seitlich geöffnete Tasche gebildet ist.

6. Leuchte nach einem der vorhergehenden Ansprüche, wobei das Leuchtmittel (8), insbesondere die vollständige Seite des Leuchtmittelträgers, auf welcher das Leuchtmittel (8) angeordnet ist, frei von Vergussmasse (10) bleibt.

7. Leuchte nach Anspruch 6, wobei zwischen dem Leuchtmittel (8) und dem transparenten Abschnitt (3) ein Hohlraum gebildet ist.

8. Leuchte nach einem der Ansprüche 1 bis 4, wobei die Vergussmasse (10) transparent ist und einen Bereich zwischen dem Leuchtmittel (8) und dem transparenten Abschnitt (3), vorzugsweise vollständig, ausfüllt, wobei die Vergussmasse (10) insbesondere einen Brechungsindex aufweist, der sich weniger als 15% von dem Brechungsindex des transparenten Abschnitts (3) auf der dem Leuchtmittel zugewandten Seite unterscheidet.

9. Leuchte nach einem der vorhergehenden Ansprüche, wobei der transparente Abschnitt (3) eine nicht-ebene Oberflächengeometrie aufweist, welche durch Lichtbrechung und/oder Lichtreflexion eine Änderung der Lichtverteilung des von dem Leuchtmittel abgegebenen Lichts hervorruft.

10. Leuchte nach einem der vorhergehenden Ansprüche, wobei der Leuchtenkörper (2) als ein sich längs erstreckendes Profils ausgebildet ist, und der Leuchtmittelträger (4) mehreren Leuchtmittel (8) entlang des Profils aufweist.

11. Leuchte nach einem der vorhergehenden Ansprüche, wobei in dem Leuchtenkörper (2) in einem Bereich, vorzugsweise in einem Hohlraum, zwischen dem Leuchtmittelträger (4) und dem transparenten Abschnitt (3) das lichtlenkende Element, insbesondere ein Reflektor (5), angeordnet ist.

12. Leuchte nach einem der vorhergehenden Ansprüche, wobei an dem Leuchtmittelträger (4) und/oder an dem Leuchtenkörper (2) ein Federelement (12) durch die Vergussmasse (10) fixiert ist.

13. Leuchte nach einem der vorhergehenden Ansprüche, wobei die Vergussmasse (10) die gesamte Oberfläche des Leuchtmittelträgers (4), welche nicht vom Leuchtenkörper (2) oder einem Hohlraum in diesem abgedeckt ist, bedeckt und insbesondere eine elektrische Isolierung und/oder eine feuchtigkeitsdichte Versiegelung des Leuchtmittelträgers (2) bildet.

14. Leuchte nach einem der vorhergehenden Ansprüche, wobei ein Endabschnitt einer elektrischen Anschlussleitung des Leuchtmittelträgers (4) durch die Vergussmasse (10) eingegossen ist.

15. Verfahren zum Herstellen einer Leuchte nach einem der vorhergehenden Ansprüche, wobei eine Leuchte vorgesehen ist, umfassend einen vorgeformten Leuchtenkörper (2) mit einem transparenten Abschnitt, der eine Lichtaustrittsfläche der Leuchte bildet, und einen flächigen Leuchtmittelträger (4), welcher wenigstens ein Leuchtmittel (8), insbesondere eine oder mehrere LEDs, sowie elektrische Kontaktierungsmittel für das Leuchtmittel (8) aufweist, und wobei ein lichtlenkendes Element vorgesehen ist, um das Licht der Leuchtmittel zum transparenten Abschnitt (3) des Leuchtenkörpers (2) umzulenken, wobei in einem ersten Verfahrensschritt der Leuchtmittelträger (4) an dem Leuchtenkörper (2) seitlich des transparenten Abschnitts (3) in einem Ausschnitt des Leuchtenkörpers (2) vormontiert wird und in einem nachfolgenden Verfahrensschritt eine Vergussmasse (10) aufgebracht wird.

## Claims

1. Luminaire, comprising a preformed luminaire body with a transparent section, which forms a light exit surface of the luminaire, and a flat luminous means mount (4) having at least one luminous means (8), in particular one or more LED's, as well as electrical contact-making means for the luminous means (8), wherein the luminous means mount (4) is inserted in a section of the luminaire body (2), and is then fixed to the luminaire body by means of a potting compound (10), which is different from the transparent section (3) of the luminaire body (2), after curing, **characterized in that** the luminous means mount (4) is arranged laterally to the transparent section (3) in a cut-out aperture, and a light-deflecting element (5) is provided, in order to deflect the light of the luminous means to the transparent section (3) of the luminaire body (2).

2. Luminaire according to claim 1, wherein the cut-out aperture is formed by opposing elements (6, 6') which engage in positive fit in the luminous means mount (4), in particular, enter into a latch engagement connection with the luminous means mount or are aligned for sliding the luminous means mount into the luminaire body.

3. Luminaire according to claim 2, wherein the opposing elements (6, 6') of the cut-out aperture are aligned, in order to hold the luminous means mount (4) in position already before the fixing by the potting compound to the luminaire body.

4. Luminaire according to any one of the preceding claims, wherein the luminous means mount (4) is arranged in the cut-out aperture, with a side comprising the luminous means (8) laterally to the transparent section (3).

5. Luminaire according to any one of claims 1 to 4, wherein the cut-out aperture is formed by a pocket open laterally to the transparent section (3).

6. Luminaire according to any one of the preceding claims, wherein the luminous means (8) remain free of potting compound (10), in particular the complete side of the luminous means mount on which the luminous means (8) is arranged.

7. Luminaire according to claim 6, wherein a hollow space is formed between the luminous means (8) and the transparent section (3).

8. Luminaire according to any one of claims 1 to 4, wherein the potting compound (10) is transparent and fills out a region between the luminous means (8) and the transparent section (3), preferably completely, wherein the potting compound (10) exhibits in particular a refractive index which differs by less than 15% from the refractive index of the transparent section (3) on the side facing the luminous means.

9. Luminaire according to any one of the preceding claims, wherein the transparent section (3) exhibits an uneven surface geometry, which by light refraction and/or light reflection incurs a change in the light distribution of the light emitted by the luminous means.

10. Luminaire according to one of the preceding claims, wherein the luminaire body (2) is configured as a profile extending lengthways, and the luminous means body (4) comprises a plurality of luminous means (8) along the profile.

11. Luminaire according to any one of the preceding claims, wherein the light-deflecting element, in particular a reflector (5), is arranged in the luminaire body (2) in a region, preferably in a hollow space, between the luminous means mount (4) and the transparent section (3).

12. Luminaire according to any one of the preceding claims, wherein a spring element (12) is fixed by the potting compound (10) to the luminous means mount (4) and or to the luminaire body (2).

13. Luminaire according to any one of the preceding claims, wherein the potting compound (10) covers the entire surface of the luminous means mount (4) which is not covered by the luminaire body (2) or by a hollow space therein, and, in particular, forms an electrical insulation and/or a moisture-tight sealing of the luminous means mount (2) [*sic 4?*].

14. Luminaire according to any one of the preceding claims, wherein an end section of an electrical connection lead of the luminous means mount (4) is cast in place by the potting compound (10).

15. Method for manufacturing a luminaire according to any one of the preceding claims, wherein a luminaire is provided, comprising a pre-formed luminaire body (2) with a transparent section, which forms a light exit surface of the luminaire, and a flat luminous means mount (4) having at least one luminous means (8), in particular one or more LED's, as well as electrical contact-making means for the luminous means (8), wherein the luminous means mount (4) is inserted in a section of the luminaire body (2), and is then fixed to the luminaire body by means of a potting compound (10), which is different from the transparent section (3) of the luminaire body (2), after curing, **characterized in that** the luminous means mount (4) is arranged laterally to the transparent section (3) in a cut-out aperture, and a light-deflecting element (5) is provided, in order to deflect the light of the luminous means to the transparent section (3) of the luminaire body (2), wherein, in a first method step, the luminous means mount (4) is pre-fitted to the luminaire body (2) laterally of the transparent section (3) in a cut-out aperture of the luminaire body (2), and, in a subsequent method step, a potting compound (10) is applied.

## Revendications

1. Lampe comprenant un corps de lampe (2) pré-moulé avec une portion transparente, qui constitue une surface de sortie de lumière de la lampe et un support de moyen d'éclairage plat (4), qui comprend au moins un moyen d'éclairage (8), plus particulièrement une ou plusieurs LED, ainsi que des moyens de contact électrique pour le moyen d'éclairage (8), le support de moyen d'éclairage (4) étant inséré dans une découpe du corps de lampe (2) puis est fixée par une masse de scellement (10), qui est distincte de la portion transparente (3) du corps de lampe (2), après le durcissement, au corps de lampe (2), **caractérisée en ce que** le support de moyen d'éclairage (4) est disposé latéralement sur la portion transparente (3) dans une découpe et un élément de déviation de lumière (5) est prévu, afin de dévier la lumière des moyens d'éclairage vers la portion transparente (3) du corps de lampe (2).

2. Lampe selon la revendication 1, la découpe étant constituée d'éléments opposés (6, 6') qui s'emboîtent par complémentarité de forme sur le support de moyen d'éclairage (4), plus particulièrement forment une liaison par encliquetage avec le support de moyen d'éclairage, ou sont conçus pour l'insertion du support de moyen d'éclairage dans le corps de lampe.

3. Lampe selon la revendication 2, les éléments opposés (6, 6') de la découpe étant conçus pour maintenir en place le support de moyens d'éclairage (4) avant la fixation par le scellement sur le corps de lampe (2).

4. Lampe selon l'une des revendications précédentes, le support de moyens d'éclairage (4) étant disposé avec un côté comportant le moyen d'éclairage (8) latéralement par rapport à la portion transparente (3) dans la découpe.

5. Lampe selon l'une des revendications 1 à 4, la découpe étant constituée d'une poche ouverte latéralement par rapport à la portion transparente (3).

6. Lampe selon l'une des revendications précédentes, le moyen d'éclairage (8), plus particulièrement le côté entier du support de moyen d'éclairage, sur lequel le moyen d'éclairage (8) est disposé, reste exempt de masse de scellement (10).

7. Lampe selon la revendication 6, un espace creux étant formé entre le moyen d'éclairage (8) et la portion transparente (3).

8. Lampe selon l'une des revendications 1 à 4, la masse de scellement étant transparente et remplissant une zone entre le moyen d'éclairage (8) et la portion transparente (3), de préférence entièrement, la masse de scellement (10) présentant plus particulièrement un indice de réfraction qui se distingue de moins de 15 % de l'indice de réfraction de la portion transparente (3) sur le côté orienté vers le moyen d'éclairage.

9. Lampe selon l'une des revendications précédentes, la portion transparente (3) présentant une géométrie de surface non plane qui provoque, par réfraction de la lumière et/ou par réflexion de la lumière, une variation de la répartition de la lumière émise par le moyen d'éclairage.

10. Lampe selon l'une des revendications précédentes, le corps de lampe (2) étant conçu comme un profilé s'étendant longitudinalement et le support de moyen d'éclairage (4) comprenant plusieurs moyens d'éclairage (8) le long du profilé.

11. Lampe selon l'une des revendications précédentes, l'élément de déviation de lumière, plus particulièrement un réflecteur (5), se trouvant dans le corps de lampe (2), dans une zone, de préférence un espace creux, entre le support de moyen d'éclairage (4) et portion transparente (3).

12. Lampe selon l'une des revendications précédentes, un élément à ressort (12) étant fixé par la masse de scellement (10) sur le support de moyen d'éclairage (4) et/ou sur le corps de lampe (2).

13. Lampe selon l'une des revendications précédentes, la masse de scellement (10) recouvre toute la surface du support de moyens d'éclairage (4), qui n'est pas recouverte par le corps de lampe (2) ou un espace creux dans celui-ci et plus particulièrement constitue une isolation électrique et/ou un scellement étanche à l'humidité du support de moyens d'éclairage (2).

14. Lampe selon l'une des revendications précédentes, une portion d'extrémité d'une ligne de raccordement du support de moyens d'éclairage (4) étant coulée par la masse de scellement (10).

15. Procédé de fabrication d'une lampe selon l'une des revendications précédentes, une lampe étant prévue, comprenant un corps de lampe pré-moulé (2) avec une portion transparente, qui constitue une surface de sortie de lumière et un support de moyens d'éclairage plat (4) qui comprend au moins un moyen d'éclairage (8), plus particulièrement une ou plusieurs LED, ainsi que des moyens de contact électrique pour le moyen d'éclairage (8) et un élément de déviation de lumière étant prévu, afin de dévier la lumière des moyens d'éclairage vers la portion transparente (3) du corps de lampe (2), dans une première étape de procédé, le support de moyens d'éclairage (4) étant pré-monté sur le corps de lampe (2) latéralement par rapport à la portion transparente (3) dans une découpe du corps de lampe (2) et dans une étape de procédé suivante, une masse de scellement (10) étant appliquée.
